# EUROPÄISCHE PATENTSCHRIFT

(11) **EP 0 483 058 B1**
(45) Veröffentlichungstag und Bekanntmachung des Hinweises auf die Patenterteilung: **30.08.1995**
(21) Anmeldenummer: 91810778.0
(22) Anmeldetag: 04.10.1991
(51) Int. Cl.: H01L 23/367

(54) **Kühlkörper für Halbleiterbauelemente**
Heat sink for semiconductor components
Refroidisseur pour composants semi-conducteurs

(30) Priorität: 24.10.1990 CH 3403/90
(43) Veröffentlichungstag der Anmeldung: 29.04.1992
(73) Patentinhaber: ALUSUISSE-LONZA SERVICES AG, 8034 Zürich (CH)
(72) Erfinder: Bock, Uwe, W-7700 Singen/Hohentwiel (DE)

(56) Entgegenhaltungen:
- EP-A- 0 206 980
- GB-A- 2 079 052
- PATENT ABSTRACTS OF JAPAN, vol. 7, no. 129 (E-179)(1274), 4. Juni 1983 ; & JP-A-58 046 660

## Beschreibung

Die Erfindung betrifft einen Kühlkörper für Halbleiterbauelemente oder dgl., insbesondere aus stranggepresstem Aluminium oder dgl. Leichtmetall, mit in Abstand zueinander von einer Grundplatte aufragenden Kühlrippen, wobei die Grundplatte an einer Oberfläche Einsatznuten aufweist, in welchen jeweils eine getrennt von der Grundplatte hergestellte Kühlrippe mit einem Sockel festgelegt ist und die Kühlrippen an ihren von der Grundplatte entfernten Seiten freie Enden aufweisen.

Kühlrippen dieser Art sind der DE-PS 35 18 310 zu entnehmen; nach deren Lehre werden stranggepresste Vollprofile mit seitlichen Ausformungen als Kühlrippen in die Einsatznuten der Grundplatte formschlüssig eingesetzt.

Die DE-PS 35 18 310 erwähnt sog. Rippenverhältnisse von mehr als 12 : 1, womit die Grenze der erreichtbaren Oberfläche bestimmt ist. Sowohl technische als auch wirtschaftliche Gesichtspunkte erfordern je nach Rippenhöhe eine Mindestrippendicke. Die Fertigung eines Kühlkörpers mit dünnen Rippen bei hoher Rippenzahl geht wegen des grösseren Aufwandes zu Lasten der Wirtschaftlichkeit.

In Kenntnis dieses Standes der Technik hat sich der Erfinder die Aufgabe gestellt, bei einer einfachen Ausführung des eingangs erwähnten Kühlkörpers das Rippenverhältnis weitergehend zu erhöhen, ohne den Arbeitsaufwand zur Fertigung des Kühlkörpers zu vermehren.

Zur Lösung dieser Aufgabe führt, dass die Kühlrippen als Hohlprofile mit zwei zueinander parallelen Seitenwänden und zwei diese randständig verbindenden Querwänden sowie einer weiteren zwischen den randständigen Querwänden angeordneten Querwand ausgebildet sind, und jeweils eine randständige Querwand jeder Kühlrippe als Kupplungssockel ausgebildet ist.

Der in Patent ABSTRACTS OF JAPAN vol.7, no. 129 (E-179) (1274) 4. Juni 1983 & JP-A-58 046 660 beschriebene Gegenstand stellt einen Kühlkörper dar, der aus einer Vielzahl von Leiterförmigen Kühlrippen zwischen zwei Tragplatten besteht.

Die Herstellung eines Kühlkörpers mit den erfindungsgemäß beschriebenen Kühlkörpern wird erheblich vereinfacht, da statt einer Kühlrippe in gleicher Arbeitszeit deren zwei eingefügt werden können. Auch vermag man die strangpreßtechnisch erforderliche Mindestdicke erheblich zu reduzieren und eine höhere Stabilität gegenüber Einzelrippen zu erreichen. Diese Stabilität verhindert u. a. ein Verbiegen bei spanabhebender Bearbeitung.

Im Rahmen der Erfindung hat es sich als günstig erwiesen, die Kühlrippen so auf der Grundplatte anzuordnen, daß die Weite des Kühlrippenhohlraumes etwa den lichten Abständen der Kühlrippen entspricht.

Erfindungsgemäß weist die Seitenwand der Kühlrippe beidseits eine gewellte Außenkontur auf, wobei die Wellentäler der Seitenwand an deren einen Außenfläche zu den Wellentälern der anderen Seitenwandfläche höhenversetzt sein sollen. Auch diese Maßgabe trägt zur Verminderung des erforderlichen Querschnittes erheblich bei.

Weitere erfinderische Schritte sind den Unteransprüchen zu entnehmen.

Weitere Vorteile, Merkmale und Einzelheiten der Erfindung ergeben sich aus der nachfolgenden Beschreibung eines bevorzugten Ausführungsbeispiels sowie anhand der Zeichnung; diese zeigt in:
- Fig. 1:: die Frontansicht eines Kühlkörpers mit Kühlrippen in einem Gehäuse;
- Fig. 2:: eine gegenüber Fig. 1 vergrößerte Darstellung einer Kühlrippe;
- Fig. 3:: ein vergrößertes Detail der Fig. 2;
- Fig. 4,5:: einen vergrößerten Abschnitt des Gehäuses.

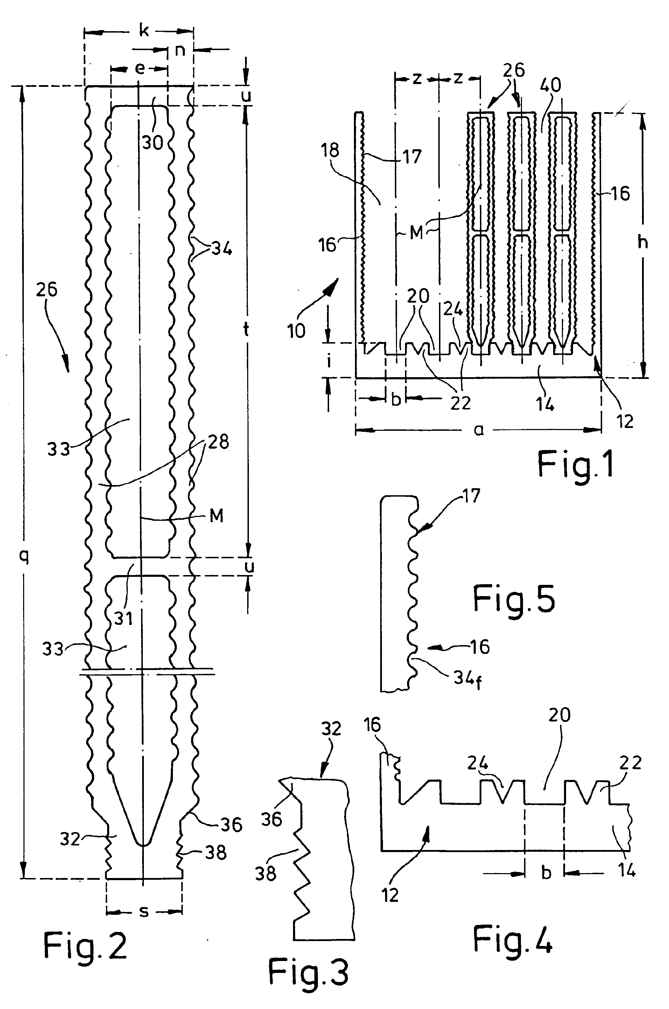

Ein Kühlkörper 10 aus Leichtmetall für in der Zeichnung aus Gründen der Übersichtlichkeit nicht weiter dargestellte Halbleiterbauelemente weist gemäß Fig. 1 ein Gehäuse 12 aus einer Grundplatte 14 der Breite a von hier 64,5 mm und einer Dicke i von beispielsweise 9 mm sowie zwei an diese angeformte Flankenwände 16 auf, wobei die Gesamthöhe h des Gehäuses 12 im gewählten Beispiel 68 mm mißt.

In die Grundplatte 14 sind -- zum Gehäuseinnenraum 18 hin offene -- Einsatznuten 20 einer Breite b von etwa 5 mm eingeformt, die Bodenrippen 22 voneinander trennen; in jede dieser Bodenrippen 22 ist eine querschnittlich V-förmige Zwischennut 24 eingeformt. In den Einsatznuten 20 sind Kühlrippen 26 festgelegt.

Die Grundplatte 14 und die Kühlrippen 26 werden getrennt hergestellt und zwar jeweils auf dem Wege des Strangpressens von Leichtmetallprofilen.

Die Kühlrippe 26 ist als Hohlprofil der Länge q von 62 mm ausgebildet; zwei gewellt profilierte parallele Seitenwände 28 der Breite n von hier 1,75 mm sind an ihren Enden durch eine Kopfwand 30 und einen Kupplungssockel 32 sowie außerdem durch eine etwa in ihrer Höhenmitte verlaufende Querwand 31 -- einer beispielsweisen Dicke n von 1,2 mm -- so verbunden, daß in der Kühlrippe 26 zwei Hohlräume 33 etwa gleicher Höhe t und einer lichten Weite e von etwa 4 mm entstehen.

Sowohl die zueinander weisenden Wellentäler 34 der Seitenwände 28 in den Hohlräumen 33 sind zueinander höhenversetzt als auch die Wellentäler 34 an den beiden Außenflächen jeder Seitenwand 28. Im übrigen sind auch in die Innenflächen 17 der Flankenwände 16 des Gehäuses 14 solche Wellentäler 34_{f} eingeformt.

Der Kupplungssockel 32 der Kühlrippe 26 verjüngt sich von einer Kühlrippenbreite k von etwa 73 mm durch geneigte Wandstücke 36 auf eine Sockelbreite s von etwa 5 mm, so daß der Kupplungssockel 32 in den Einsatznuten 20 entsprechender Breite klemmend gehalten wird. Zur Lagesicherung sind -- wie Fig. 2, 3 zeigt -- querschnittlich sägezahnartige Längseinformungen 38 vorgesehen, außerdem können dank jener Zwischennuten 24 die Bodenrippen 22 mittels eines Werkzeuges zur Verbesserung des Preßdruckes verformt werden.

Die Abstände z der Mittelachsen M der Kühlrippen 26 messen etwas mehr als 10 mm, so daß die Kühlrippenzwischenräume 40 etwa der Hohlraumweite e entsprechen.

## Patentansprüche

1. Kühlkörper für Halbleiterbauelemente oder dgl., insbesondere aus stranggepresstem Aluminium oder dgl. Leichtmetall, mit in Abstand zueinander von einer Grundplatte aufragenden Kühlrippen, wobei die Grundplatte an einer Oberfläche Einsatznuten aufweist, in welchen jeweils eine getrennt von der Grundplatte hergestellte Kühlrippe mit einem Sockel festgelegt ist und die Kühlrippen an ihren von der Grundplatte entfernten Seiten freie Enden aufweisen,
dadurch gekennzeichnet, dass
die Kühlrippen (26) als Hohlprofil mit zwei zueinander parallelen Seitenwänden (28) und zwei diese randständig verbindenden Querwänden (30, 32) sowie einer weiteren zwischen den randständigen Querwänden (30, 32) angeordneten Querwand (31) ausgebildet sind, und jeweils eine randständige Querwand (32) jeder Kühlrippe (26) als Kupplungssockel (32) ausgebildet ist.

2. Kühlkörper nach Anspruch 1, dadurch gekennzeichnet, dass die zwischen den randständigen Querwänden (30, 32) befindliche Querwand (31) mittig zur Kühlrippenhöhe angeordnet ist.

3. Kühlkörper nach einem der Ansprüche 1 oder 2, dadurch gekennzeichnet, dass sich der durch die zwischen den randständigen Querwänden (30, 32) angeordnete Querwand (31), den Kupplungssockel (32) und die Seitenwände (28) begrenzte sockelnahe Hohlraum (33) nach unten hin V-förmig verjüngt.

4. Kühlkörper nach einem der Ansprüche 1 bis 3, dadurch gekennzeichnet, dass das Kupplungsende des Kupplungssockels (32) schmaler ist als die Kühlrippenbreite (k).

5. Kühlkörper nach einem der Ansprüche 1 bis 4, dadurch gekennzeichnet, dass die Weite (e) des Kühlrippenhohlraumes (33) dem lichten Abstand zweier Kühlrippen (26) entspricht.

6. Vorrichtung nach einem der Ansprüche 1 bis 5, dadurch gekennzeichnet, dass die Seitenwand (28) der Kühlrippe (26) beidseits eine gewellte Aussenkontur aufweist.

7. Kühlkörper nach Anspruch 6, dadurch gekennzeichnet, dass die querschnittlichen Wellentäler (34) der einen Aussenfläche der Seitenwand (28) zu den Wellentälern der anderen Seitenwandfläche höhenversetzt sind.

8. Kühlkörper nach einem der Ansprüche 1 bis 7, dadurch gekennzeichnet, dass die beiden den Hohlraum (33) begrenzenden Seitenwandflächen zueinander höhenversetzte Wellentäler (34) aufweisen.

9. Kühlkörper mit von der Grundplatte aufragenden seitlichen Flankenwänden nach einem der Ansprüche 1 bis 8, dadurch gekennzeichnet, dass die einander zugekehrten Innenflächen (17) der Flankenwände (16) mit querschnittlichen Wellentälern (34_{f}) ausgestattet sind.

## Claims

1. Heat sink for semiconductor components or similar devices, especially a heat sink that is made of extruded aluminium or similarly extruded light metal, with cooling fins which, spaced one from another, project upwards from a baseplate that presents insertion slots on one surface, into each of which a cooling fin with a base is fixed, these cooling fins being manufactured separately from the baseplate and having exposed free ends on their sides remote from said baseplate, characterized in that the cooling fins (26) are formed as hollow profile-sections with two mutually parallel side walls (28) which are connected by two marginal transverse walls (30, 32), and with an additional transverse wall (31) which is located between said marginal transverse walls (30, 32), one of the marginal transverse walls of each cooling fin (26) being shaped to serve as an attachment base (32).

2. Heat sink according to Claim 1, characterized in that the transverse wall (31) between the marginal transverse walls (30, 32) is located at the mid-height of the cooling fin.

3. Heat sink according to Claim 1 or Claim 2, characterized in that the cavity (33) which is adjacent to the base becomes narrower in the downward direction, in the shape of a 'V', this cavity (33) being delimited by the transverse wall (31) which is located between the marginal transverse walls (30, 32), by the attachment base (32), and by the side walls (28).

4. Heat sink according to any one of Claims 1 to 3, characterized in that the attachment end of the attachment base (32) is narrower than the cooling-fin width (k).

5. Heat sink according to any one of Claims 1 to 4, characterized in that the width (e) of the cooling-fin cavity (33) corresponds to the clearance between two adjacent cooling fins (26).

6. Device according to any one of Claims 1 to 5, characterized in that the side wall (28) of the cooling fin (26) has a profile that presents a corrugated surface on each of its two sides.

7. Heat sink according to Claim 6, characterized in that the cross-sectional corrugation-troughs (34) on one, outer surface of the side wall (28) are vertically staggered with respect to the corrugation-troughs on the other surface.

8. Heat sink according to any one of Claims 1 to 7, characterized in that the two side-wall surfaces delimiting the cavity (33) present corrugation-troughs (34) which are vertically staggered with respect to one another.

9. Heat sink with lateral flanking walls which project upwards from the baseplate, according to any one of Claims 1 to 8, characterized in that the opposing inside surfaces (17) of the flanking walls (16) are provided with cross-sectional corrugations, with troughs (34f).

## Revendications

1. Refroidisseur pour des composants semiconducteurs ou analogues, en particulier en aluminium ou en métal léger analogue extrudés, avec des nervures de refroidissement faisant saillie à distance les unes des autres d'une plaque de base, la plaque de base présentant des rainures d'insertion à une surface, dans lesquelles, chaque fois, une ailette de refroidissement, réalisée séparée de la plaque de base, est fixée avec un socle, et les ailettes de refroidissement présentant, à leur côté éloigné de la plaque de base, des extrémités libres, caractérisé en ce que les ailettes de refroidissement (26) sont constituées comme un profilé creux, avec deux parois latérales (28) parallèles l'une à l'autre et deux parois transversales (30, 32) reliant celles-ci, se trouvant au bord, ainsi qu'une autre paroi transversale (31) agencée entre les parois transversales (30, 32), se trouvant au bord, et en ce que, chaque fois, une paroi transversale (32), se trouvant au bord de chaque ailette de refroidissement (26), est constituée comme un socle d'accouplement (32).

2. Refroidisseur selon la revendication 1, caractérisé en ce que la paroi transversale (31), se trouvant entre les parois transversales (30, 32) se trouvant au bord, est agencée au milieu par rapport à la hauteur de l'ailette de refroidissement.

3. Refroidisseur selon une des revendications 1 ou 2, caractérisé en ce que l'espace creux (33) proche du socle, limité par la paroi transversale (31) agencée entre les parois transversales (30, 32) se trouvant au bord, le socle d'accouplement (32) et les parois latérales (28), va en se rétrécissant vers le bas en forme de V.

4. Refroidisseur selon une des revendications 1 à 3, caractérisé en ce que l'extrémité d'accouplement du socle d'accouplement (32) est plus étroite que la largeur d'ailette de refroidissement (k).

5. Refroidisseur selon une des revendications 1 à 4, caractérisé en ce que la largeur (2) de l'espace creux de l'ailette de refroidissement (33) correspond à l'espacement de passage libre de deux ailettes de refroidissement (26).

6. Dispositif selon une des revendications 1 à 5, caractérisé en ce que la paroi latérale (28) de l'ailette de refroidissement (26) présente des deux côtés un contour extérieur ondulé.

7. Refroidisseur selon la revendication 6, caractérisé en ce que les fonds d'ondulation (34) de coupe transversale de l'une des surfaces extérieures de la paroi latérale (26) sont décalés en hauteur par rapport aux fonds d'ondulation de l'autre surface de paroi latérale.

8. Refroidisseur selon une des revendications 1 à 7, caractérisé en ce que les deux surfaces de paroi latérale limitant l'espace creux (33) présentent des fonds d'ondulation (34) décalés en hauteur les uns par rapport aux autres.

9. Refroidisseur avec des parois de flancs latérales faisant saillie de la plaque de base selon une des revendications 1 à 8, caractérisé en ce que les surfaces intérieures (17) orientées l'une vers l'autre des parois de flancs (16) sont pourvues de fonds d'ondulation (34_{f}) en coupe transversale.
